# EUROPEAN PATENT APPLICATION

(11) **EP 4 837 712 A1**
(43) Date of publication of application: **11.11.2026**
(21) Application number: 26176848.5
(22) Date of filing: 06.05.2026
(51) Int. Cl.: B25J 15/02, B25J 9/10, B25J 11/00, B25J 17/02, H10W 72/00

(54) **HANDLING DEVICE FOR A SUPPORT**

(30) Priority: 08.05.2025 IT 202500010347
(71) Applicant: AMX - Automatrix S.r.l., 25077 Roè Volciano (BS) (IT)
(72) Inventor: SCHIVALOCCHI, Nicola, 25077 Roe' Volciano, BRESCIA (IT)
(74) Representative: Chimini, Francesco

(57) **Abstract**

A handling device (7) for moving a support (8) for at least one product to be sintered (P) by means of a sintering press, comprising: a first support element (12) suitable for being connected to a support structure; a second gripping element (13) comprising support gripping means (15), suitable for gripping, holding and releasing the support (8); a handling arm (11a) pivotally connected to the first support element (12) and to the second gripping element (13), so as to connect the first support element (12) to the second gripping element (13); the handling arm (11a) being pivotally connected to the first support element (12) by means of a motorized oscillation joint (14a). The handling device (7) further comprises support stabilization means suitable for maintaining the support gripping means (15) in a predetermined support handling orientation, independently of the angular position of the second gripping element (13) with respect to the first support element (12).

## Description

The present invention belongs to the field of sintering presses for electronic components on a substrate.

In particular, the object of the present invention is a handling device for moving a support for at least one product to be sintered by means of a sintering press.

Furthermore, a handling system for moving a support, a sintering press for a sintering process and a sintering method of at least one product to be sintered on at least one substrate form the object of the present invention.

In the sector, numerous examples are known of handling devices for moving a support within industrial machines, in particular within sintering presses, for a sintering process of electronic components on a substrate.

In general, the sintering process consists of hardening or bonding particles of material, usually made of metal or ceramic, by means of heating and compression. A sintering press is a machine used in such process, which compacts the powders or the granules of a material into solid form by applying high pressure, but without completely melting the material.

The pressure sintering process is typically used in numerous electronic applications, to produce a variety of electronic components requiring materials with high electrical conductivity, thermal resistance, or other specific properties, or to fasten to a substrate, by interposing a sintering paste, devices, such as Insulated Gate Bipolar Transistors (IGBT), thermistors, or Metal-Oxide-Semiconductor Field-Effect Transistors (MOSFET).

A "sintering paste" is understood to mean a mixture of metal or ceramic powders, or similar materials, which is applied to a surface to promote the joining of particles under the effect of heat and pressure, during the sintering process.

A "substrate" is understood to mean not only an electronic board, but also other types of support for electronic components, e.g., heat dissipators, or "heatsinks".

In further applications, the device of the sintering process may be composed of a casing containing the electronic board, formed by electronic components and substrate, on a dissipative element.

Inside a sintering press, the correct positioning and the correct handling of the substrate must be ensured within the machine in order for each product to be correctly sintered.

Such substrates are typically positioned within or above a special support to ensure the correct handling thereof within the machine body.

A commonly used method for moving the support within the sintering press comprises the use of a system consisting of independent motorized axes.

However, a typical problem of such solution lies in the fact that such independent motorized axes cannot extend to reach all positions of the sintering press, due to the volume of the motorized axes, which causes general difficulty of movement of the support inside the narrow spaces of the machine body.

For example, such problem typically prevents the motorized axes from positioning the support at different height levels within the sintering press, limiting the effectiveness of the entire sintering process.

Another typical problem of such solution lies in the elevated temperatures reached in certain areas of the sintering press during the sintering process, which often damage the motorized axes, compromising the working of the entire sintering process.

Therefore, the need is still strongly felt to easily move a support within a sintering press, however, without incurring the limitations and drawbacks typical of the aforesaid prior art.

It is therefore the object of the present invention to meet such need, by suggesting a handling device, which allows the support to be moved efficiently within a sintering press.

A further object of the present invention is to provide a handling device, which ensures the smallest possible occupied volume during all movements, allowing the size of the sintering press to be kept small.

Finally, it is also an object of the present invention to suggest a handling device, which has the option of moving the support freely within the sintering press, without being limited by the presence of high temperatures in certain areas of the sintering press.

This and other objects are achieved by virtue of a handling device for moving a support according to the appended claim 1. Such objects are further achieved by virtue of a handling system for moving a support according to claim 12, a sintering press according to claim 16, and a sintering method according to claim 19.

The dependent claims describe preferred or advantageous embodiments of the invention.

The features and advantages of the handling device, the handling system, the sintering press and the sintering method according to the invention will nonetheless become apparent from the following description of preferred embodiments thereof, given by way of non-limiting example, with reference to the accompanying figures, in which:
- figure 1 shows a perspective view of the handling device according to the invention, when the latter is in the vertical configuration;
- figure 2 shows a side view of the handling device according to the invention, when the latter is in the retracted configuration;
- figure 3 shows a side view of the handling device according to the invention, when the latter is in the horizontal configuration;
- figure 4 shows a side view of the handling device according to the invention, when the latter is in the vertical configuration;
- figure 5 shows an embodiment of a sintering press comprising a handling device according to the invention;
- figure 6 is a block diagram of the method of sintering according to the present invention, in an embodiment; and
- figure 7 is a block diagram of the method of sintering of figure 6, in an alternative embodiment.

In the remainder of the present document, alldirectional references (e.g., upper, lower, upward, downward, left, right, to the left, to the right, at the top, at the bottom, above, below, vertical, horizontal, clockwise and anti-clockwise) are used solely for identification purposes to assist the reader in understanding the described embodiments and do not create limitations, in particular with regard to the position, orientation, or use of the described embodiments.

Furthermore, coupling terms (for example, fastened, coupled, connected, and the like) are to be interpreted broadly and may include intermediate elements between connection elements and relative movement between elements.

Therefore, the coupling terms do not necessarily imply that two elements are directed connected and in a fixed relationship with each other.

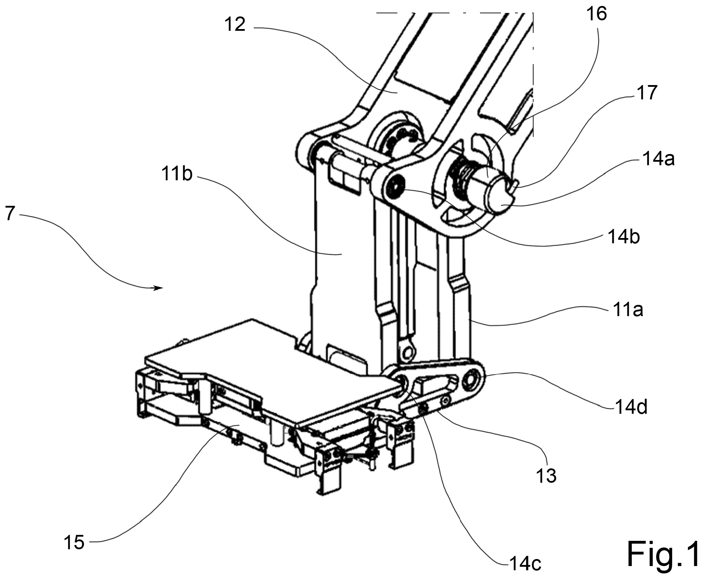

In said drawings, reference numeral 7 globally indicates a handling device, according to the invention, shown by way of example in figure 1.

In a general embodiment, the handling device 7 is suitable for moving a support 8 for at least one product P to be sintered by means of a sintering press.

In the remainder of the present description, a "product to be sintered P on a substrate" shall be understood to mean an electronic component to be sintered and a substrate on which the electronic component must be sintered.

In some embodiments, multiple electronic components may be sintered on the same substrate.

In a general embodiment, the handling device 7 comprises a first support element 12. Such first support element 12 is suitable for being connected to a support structure.

In other words, the first support element 12 is designed to be connected to a support structure, which may be an integral part of the sintering press or an independent element. Such support structure may be fixed, that is, rigidly anchored to a portion of the sintering press, or movable, allowing the handling device 7 to be moved within the work area of the sintering press.

In a general embodiment, the handling device 7 further comprises a second gripping element 13. Such second gripping element 13 comprises support gripping means 15. Such support gripping means 15 are suitable for gripping, holding and releasing the support 8.

Preferably, the first support element 12 and the second gripping element 13 are rigid elements.

In a general embodiment, the handling device 7 comprises a handling arm 11a pivotally connected to the first support element 12 and to the second gripping element 13, so as to connect such first support element 12 to such second gripping element 13.

In a general embodiment, the handling arm 11a is pivotally connected to the first support element 12 by means of a motorized oscillation joint 14a.

In the remainder of the present description, the terms "pivotally connected" and "hinged" may be considered synonyms. Both terms indicate, for example, that the handling arm 11a is connected to the first support element 12 and to the second gripping element 13 by means of a joint, which allows the relative rotation between the elements. In other words, the handling arm 11a may rotate with respect to the first support element 12 and the second gripping element 13, allowing varying the position and orientation of the second gripping element 13 with respect to the first support element 12.

A motorized oscillation joint is a type of mechanical joint, which allows the controlled rotation of an element with respect to another. For example, the motorized oscillation joint 14a allows the handling arm 11a to rotate with respect to the first support element 12.

In a general embodiment, the handling device 7 further comprises support stabilization means suitable for keeping the support gripping means 15 in a predetermined support handling orientation, independently of the angular position of the second gripping element 13 with respect to the first support element 12.

In other words, the handling device 7 comprises support stabilization means, which ensure that the support gripping means 15 always maintain the same orientation, independently of how the second gripping element 13 moves with respect to the first support element 12. For example, even if the second gripping element 13 rotates or tilts during handling, the support 8 will always remain in the desired position, e.g., horizontal.

The handling arm 11a is preferably motorized, that is, controlled by a motor 16.

For example, the motor 16 is an electric motor.

In an embodiment, the support stabilization means comprise a stabilization arm 11b. Such stabilization arm 11b is pivotally connected to the first support element 12 and to the second gripping element 13, so as to connect such first support element 12 to such second gripping element 13.

Alternatively, the support stabilization means could comprise, for example, a second motor or a linear actuation system, such as a pneumatic or hydraulic cylinder, which acts directly on the second gripping element 13 to maintain the orientation thereof.

In an embodiment, the first support element 12, the second gripping element 13, the handling arm 11a and the stabilization arm 11b define an articulated quadrilateral.

In the remainder of the present description, an "articulated quadrilateral" shall be understood to mean a structure having four main elements, for example, the first support element 12, the second gripping element 13, the handling arm 11a and the stabilization arm 11b, connected to one another by articulation means, such as hinges or pins, forming a closed chain having four sides. Such structure allows the handling arm 11a and the stabilizing arm 11b to rotate with respect to the first support element 12 and the second gripping element 13.

The articulated quadrilateral structure allows obtaining a precise and smooth movement of the support 8, which may be accurately positioned in the different working positions within the sintering press. Furthermore, the articulated quadrilateral structure gives the handling device 7 greater compactness with respect to solutions based on linear guides or other handling systems, facilitating the integration thereof in narrow spaces. Finally, the articulated quadrilateral structure provides optimal stability during the handling of the support 8, reducing the risk of undesired vibrations or oscillations.

Such articulated quadrilateral is preferably an articulated parallelogram.

In the remainder of the present description, an "articulated parallelogram" shall be understood to mean an articulated quadrilateral structure, as described above, having opposite sides, which are parallel and of equal length. In the case of the handling device 7, this means that the first support element 12 is parallel to the second gripping element 13, and the handling arm 11a is parallel to the stabilization arm 11b.

The articulated-parallelogram configuration offers further advantages with respect to a generic articulated quadrilateral. In particular, it ensures that the support 8 always maintains the same orientation during handling, preventing undesired rotations. This is particularly important when delicate items are positioned on the support 8, or when it is necessary to position the support 8 with great angular precision. Furthermore, the articulated parallelogram makes a more linear and predictable movement of the support 8, simplifying the control of the handling device 7.

In an embodiment, the stabilizing arm 11b is pivotally connected to the first support element 12 and to the second gripping element 13 in a free manner.

In other words, the stabilization arm 11b is connected to the first support element 12 and to the second gripping element 13 by means of pins or joints, allowing it to rotate freely, without directly influencing the movement of the handling arm 11a or the other components of the handling device 7. This type of connection is referred to as "free" because it does not transmit motion, but allows the stabilization arm 11b to adapt to the movement of the handling arm 11a and keep the support 8 stable during handling.

In an embodiment, the handling arm 11a is suitable for being moved between a retracted configuration, a vertical configuration and an extended configuration.

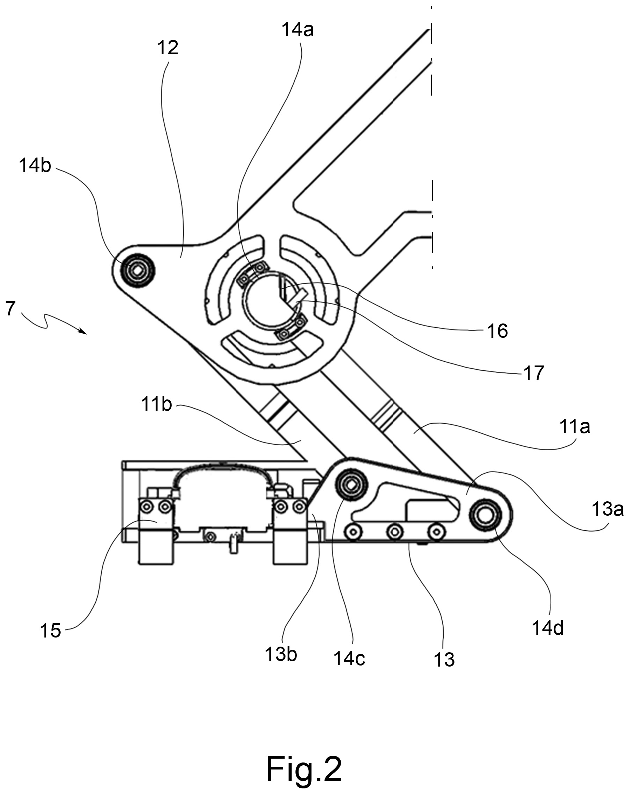

The retracted configuration, shown in figure 2, provides that the handling arm 11a is folded so as to occupy a minimum space within the sintering press. This configuration is particularly useful during the loading/unloading steps of the at least one product to be sintered P onto/from the support 8, or during the preheating and/or cooling steps, or, when it is necessary to free space inside the sintering press to perform other operations.

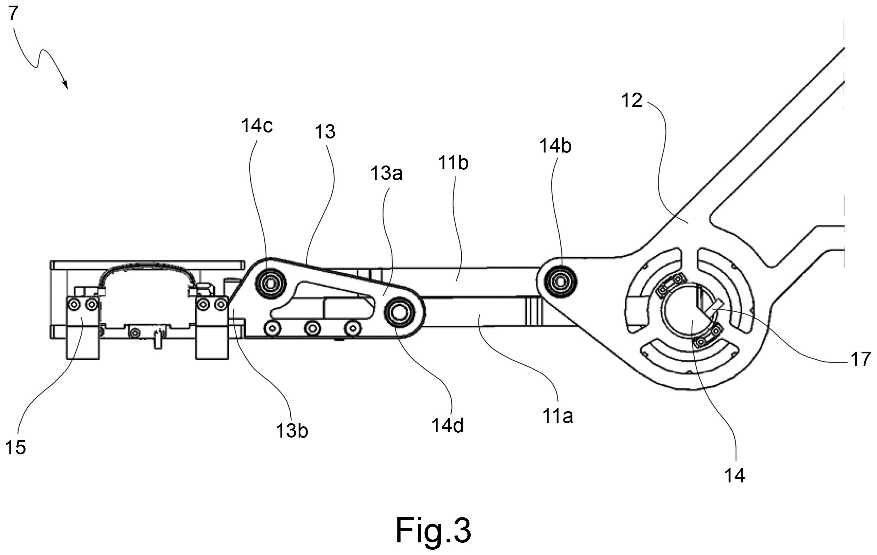

The extended configuration, shown in figure 3, provides that the handling arm 11a fully extends to reach different positions within the sintering press. This configuration allows the support 8 to be positioned at the different work stations or process zones within the sintering press. For example, the handling arm 11a may extend to position the support 8 at the lower die 10a of the sintering press, or at a preheating station 50 or a cooling station 60 for the heat treatment steps.

For example, the handling device 7, in the extended configuration, allows the support 8 to be positioned on the lower die 10a of the sintering press, which may reach temperatures, for example, comprised between 220 °C and 290 °C, keeping the handling arm 11a, sensitive to such high temperatures, sufficiently far from the hottest area of the sintering press.

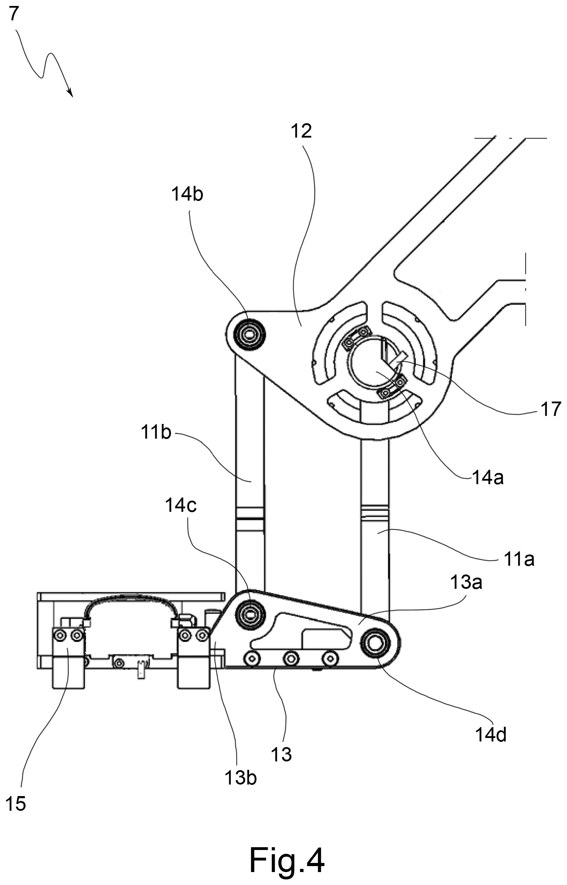

The vertical configuration, shown in figure 4, is arranged between the retracted configuration and the extended configuration. The vertical configuration provides that the handling arm 11a fully extends in height and consequently can move the support 8 in the vertical direction within the sintering press.

The option of taking different intermediate heights (or "levels") within the machine body allows optimizing the management of spaces within the sintering press, ensuring the reduced size of the machine body.

For example, the sintering press may provide one or more distinct heights for the preheating station, the cooling station, the lower die of the sintering press, and the conveyor belt for moving the support.

Furthermore, the ability to take different intermediate heights (or "levels") within the machine body allows optimizing the sintering process. For example, during the preheating or cooling steps, the support 8 may be positioned at specific levels to ensure a uniform heat treatment of the at least one product to be sintered P. Therefore, the vertical movement not only expands the options of positioning the support 8, but it also contributes to improving the effectiveness of the entire sintering process.

In an embodiment, the first support element 12 is in the form of a plate.

In an embodiment, the second gripping element 13 is in the form of a plate having a first connection portion 13a, to which the handling arm 11a is pivotally connected, and a second gripping portion 13b rigidly connected to the support gripping means 15.

In the remainder of the present description, "rigidly connected" shall be understood to mean that the second gripping portion 13b is integral with the support gripping means 15. In other words, there is no relative movement between the second gripping portion 13b and the support gripping means 15, therefore any movement of the second gripping portion 13b is transmitted directly to such support gripping means 15.

In an embodiment, the support gripping means 15 comprise a gripper.

The support gripping means 15 may be of a different nature depending on the type of support 8 and product to be sintered P. For example, they may be made with a mechanical gripper, a vacuum system, a magnetic system, or other gripping devices.

In an embodiment, the support gripping means 15 comprise a mechanical gripper.

For example, the mechanical gripper is provided with one or more movable mechanical jaws, arranged in an opposed configuration. Such movable jaws simultaneously close toward the center of the mechanical caliper, allowing the gripping of the support 8.

The mechanical gripper is preferably provided with four movable mechanical jaws.

In an embodiment, the motorized oscillation joint 14a is an articulation pin.

An "articulation pin" is a type of mechanical joint, which allows the relative rotation between two elements, e.g., the handling arm 11a and the first support element 12. The articulation pin 14a is motorized so that the rotation thereof is controlled by a motor 16.

In an embodiment, the handling arm 11a is pivotally connected to the second gripping element 13 by means of an articulation pin 14d.

In an embodiment, the stabilization arm 11b is pivotally connected to the first support element 12 and the second gripping element 13 by means of articulation pins 14b, 14c.

The distance between the articulation pins 14a and 14b preferably corresponds to the distance between the articulation pins 14c and 14d.

The motor 16 is preferably positioned close to the articulation pin 14a.

The handling arm 11a and the stabilizing arm 11b are preferably arranged symmetrically to the first support element 12 and the second gripping element 13.

The handling arm 11a and the stabilization arm 11b preferably have equal overall linear dimensions, measured between the connection point to the first support element 12 and the connection point to the second gripping element 13.

According to a further aspect, the present invention further relates to a handling system 70 for moving a support 8 for at least one product P to be sintered by means of a sintering press.

Such system comprises a handling device 7 as described above. Such system further comprises a support structure comprising device handling means 4, 5, 6, connected to the first support element 12.

In an embodiment, the device handling means 4, 5, 6 comprise at least one handling axis. Such at least one handling axis is suitable for moving the handling device 7 along at least one predefined direction X-X, Y-Y, Z-Z.

The device handling means 4, 5, 6 preferably comprise a first handling axis 4, a second handling axis 5, and a third handling axis 6, respectively, suitable for moving the handling device 7 substantially along a first horizontal direction X-X, a second horizontal direction Y-Y, and a vertical direction Z-Z.

The first horizontal direction X-X, the second horizontal direction Y-Y and the vertical direction Z-Z are preferably mutually perpendicular.

In other words, the first horizontal direction X-X, the second horizontal direction Y-Y and the vertical direction Z-Z are oriented in three spatial directions.

The third handling axis 6 is preferably connected to the first support element 12.

In an embodiment, the handling system 70 further comprises a position sensor 17.

The position sensor 17 is preferably positioned close to one of the articulation pins 14a-14d.

The position sensor 17 may be of a different type, e.g., an optical or magnetic encoder, a potentiometer, or a proximity sensor. The position sensor 17 provides a signal indicating the position of the handling device 7 or one of the components thereof, such as the handling arm 11a. This signal is used for controlling the movement of the handling device 7 and ensuring the precise positioning of the support 8.

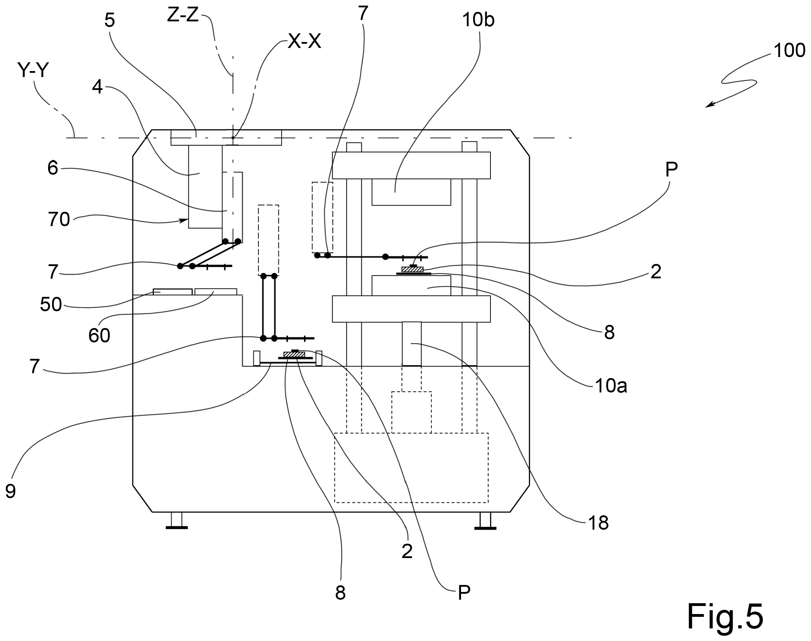

According to an even further aspect, the present invention also relates to a sintering press 100 for a sintering process of at least one product to be sintered P on a substrate, shown in figure 5.

Such sintering press 100 comprises a handling system 70 as described above.

Such sintering press 100 further comprises a lower die 10a on which a support 8 for at least one product to be sintered P is suitable for being positioned.

Such sintering press 100 further comprises an upper die 10b. At least one of the lower die 10a and the upper die 10b is movable with respect to the other, between an retracted inactive position and an advanced pressing position.

Such sintering press 100 further comprises an actuator 18 suitable for moving at least one of the lower die 10a and the upper die 10b between the retracted inactive position and the advanced pressing position.

In an embodiment, the sintering press 100 further comprises a preheating station 50 suitable for preheating the at least one product to be sintered P.

In an embodiment, the sintering press 100 further comprises a cooling station 60 suitable for cooling the at least one product to be sintered P at the end of the sintering process.

In such embodiments, the support 8 is suitable for being positioned in the preheating station 50 and in the cooling station 60.

The support 8 acts as a containing and positioning element for the at least one product to be sintered P. The structure thereof is specifically designed to accommodate and keep the at least one product to be sintered P in a stable position during the entire sintering cycle, ensuring a correct alignment with respect to the lower die 10a and the upper die 10b.

The support 8 contributes to preventing undesired movements of the at least one product to be sintered P, which could compromise the quality of the end result. Furthermore, the configuration thereof allows optimizing the space inside the sintering press 100, allowing multiple products to be sintered simultaneously, maximizing the efficiency of the process.

In an embodiment, the sintering press 100 further comprises at least one conveyor belt 9 suitable for moving the support 8.

For example, the handling device 7 is suitable for positioning the support 8 on the conveyor belt 9 when it is in the vertical configuration.

The conveyor belt 9 may be made of various materials, such as rubber, fabric or metal. The conveyor belt 9 may be driven by an electric motor or by another actuation system.

According to an even further aspect, the present invention also relates to a method of sintering at least one product to be sintered P on at least one substrate 2.

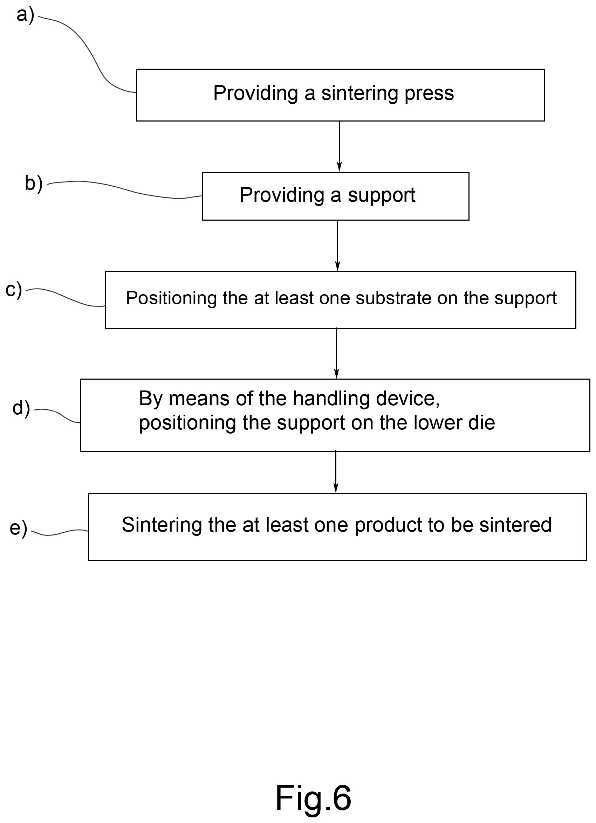

In a general embodiment, the method comprises the following operating steps, shown in figure 6.

Such method uses a sintering press 100 as described above (step a).

Such method further uses a support 8 (step b).

Such method further comprises positioning the at least one substrate 2 on the support 8 (step c).

Such method further comprises, by means of the handling device 7, positioning the support 8 on the lower die 10a (step d).

Such method finally comprises sintering the at least one product to be sintered P (step e).

Such method preferably further comprises, by means of the handling device 7, removing the at least one product to be sintered P from the lower die 10a at the end of the sintering process.

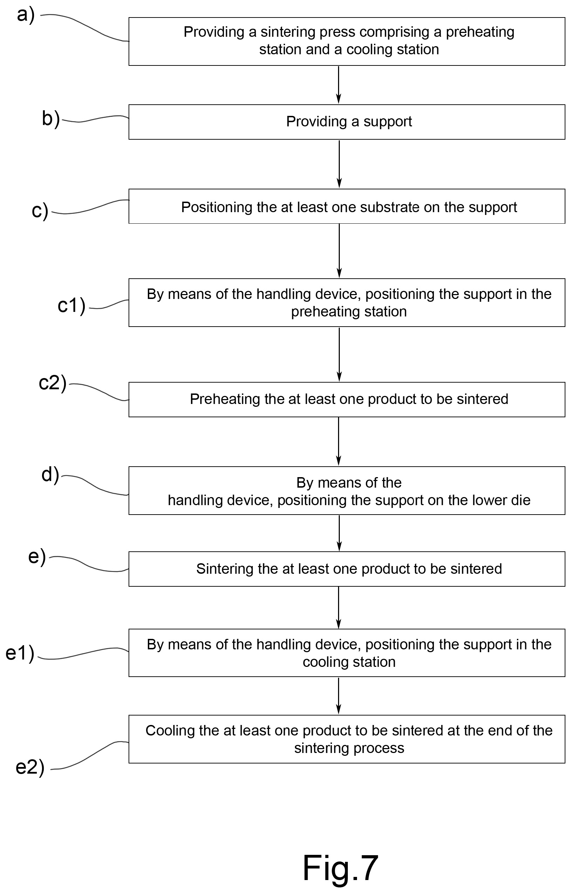

In an embodiment, shown in figure 7, the method in step a) comprises the use of a sintering press 100, further comprising a preheating station 50 suitable for preheating the at least one product to be sintered P, and a cooling station 60 suitable for cooling the at least one product to be sintered P at the end of the sintering process.

In such embodiment, the method comprises, after step c) and before step d), the following operating steps.

Such method comprises, by means of the handling device 7, positioning the support 8 in the preheating station 50 (step c1).

Such method subsequently comprises preheating the at least one product to be sintered P (step c2).

In such embodiment, the method comprises, after step e), the following operating steps.

Such method comprises, by means of the handling device 7, positioning the support 8 in the cooling station 60 (step e1).

Such method further comprises cooling the at least one product to be sintered P at the end of the sintering process (step e2).

Such method preferably further comprises, by means of the handling device 7, removing the at least one product to be sintered P from the cooling station 60 at the end of the cooling process.

The temperature of the preheating station 50 is preferably between 80 °C and 200 °C.

The temperature of the cooling station 60 is preferably between 20 °C and 40 °C.

Innovatively, the use of a handling device integrated in the sintering press offers a more efficient and controlled movement of the support with respect to conventional systems based on independent motorized axes. This results in greater precision in positioning the support and a reduction in cycle times.

The handling device is also designed to operate in the areas of the sintering press, which reach high temperatures during the process, ensuring a reliable and accurate movement, also under severe thermal conditions.

The compact structure of the handling device allows operation in all internal positions of the sintering press, also facilitating access to the narrow spaces of the machine body. This allows optimizing the use of the internal space of the sintering press and reducing the overall volume of the machine.

The presence of the stabilization arm allows the weight of the support to be better distributed, ensuring greater stability during handling. Furthermore, the fact that the stabilization arm is freely pivotally connected, favors the coordinated movement of the two arms and allows performing more complex movements.

The two arms are connected by means of articulation pins to both the first support element and the second gripping element. This configuration allows the two arms to move in a synchronized or independent manner, offering a wide range of movement options for the support.

The handling device allows the positioning of the support at different heights within the sintering press, increasing the effectiveness of the entire sintering process by means of precise positioning control.

The integration of a preheating station and a cooling station within the sintering press, together with the presence of conveyor belts, allows optimized management of the product to be sintered during the entire sintering cycle, from the preheating step to the cooling step.

The handling arm may be moved between a retracted configuration, a vertical position and an extended configuration, allowing the precise positioning of the support in different positions within the sintering press.

The option of moving the handling arm in a vertical configuration provides a further degree of freedom in positioning the support, allowing the adaptation to different process requirements.

The articulation pins, which connect the handling arm to the first support element and to the second gripping element, ensure a smooth and precise movement, without play or vibrations.

The use of an articulated quadrilateral, or articulated parallelogram, for the handling device offers greater stability and precision in moving the support, reducing the risk of undesired oscillations or vibrations.

The articulated parallelogram ensures that the support maintains the desired orientation during handling, avoiding accidental rotations.

The presence of multiple movement axes allows the handling device to move along different directions, offering great flexibility in positioning the support.

The first support element, in the form of a plate, offers a simple and effective solution for the connection to the support structure, facilitating the integration of the device.

The second gripping element, in the form of a plate with two portions, ensures a stable connection between the handling arm and the support gripping means, ensuring the correct transmission of movement.

The use of a gripper as support gripping means ensures a firm and secure grip of the support during handling.

The position sensor allows precise control of the position of the support within the sintering press, optimizing the sintering process.

The conveyor belt facilitates the movement of the support inside the sintering press, automating the process and reducing downtime.

The position sensor ensures adequate precision in the movements of the handling device.

Those skilled in the art may make changes and adaptations to the embodiments of the handling device, the handling system, the sintering press and the sintering method according to the invention, or they can replace elements with other functionally equivalent elements in order to meet contingent needs without departing from the scope of the following claims. Each of the features described as belonging to a possible embodiment may be implemented irrespective of the other described embodiments.

## Claims

1. A handling device (7) for handling a support (8) for at least one product to be sintered (P) by means of a sintering press, said handling device (7) comprising:
- a first support element (12) suitable for being connected to a support structure;
- a second gripping element (13) comprising support gripping means (15), said support gripping means (15) being suitable for gripping, holding and releasing the support (8);
- a handling arm (11a) pivotally connected to the first support element (12) and to the second gripping element (13), so as to connect said first support element (12) to said second gripping element (13);
said handling arm (11a) being pivotally connected to the first support element (12) by means of a motorized oscillation joint (14a);
- support stabilization means suitable for maintaining the support gripping means (15) in a pre-established support handling orientation, independently of the angular position of the second gripping element (13) with respect to the first support element (12).

2. Handling device (7) according to claim 1, wherein the support stabilization means comprise a stabilization arm (11b) pivotally connected to the first support element (12) and to the second gripping element (13), so as to connect said first support element (12) to said second gripping element (13).

3. Handling device (7) according to the preceding claim, wherein the first support element (12), the second gripping element (13), the handling arm (11a) and the stabilization arm (11b) define an articulated quadrilateral.

4. Handling device (7) according to any one of claims 2 to 3, wherein the stabilization arm (11b) is freely pivotally connected to the first support element (12) and to the second gripping element (13).

5. Handling device (7) according to any one of the preceding claims, wherein the handling arm (11a) is suitable for being moved between a retracted configuration, a vertical configuration and an extended configuration.

6. Handling device (7) according to any one of the preceding claims, wherein the second gripping element (13) is in the form of a plate having a first connection portion (13a) to which the handling arm (11a) is pivotally connected and a second gripping portion (13b) rigidly connected to the support gripping means (15).

7. Handling device (7) according to any one of the preceding claims, wherein the handling arm (11a) is pivotally connected to the second gripping element (13) by means of an articulation pin (14d), and wherein the stabilization arm (11b) is pivotally connected to the first support element (12) and to the second gripping element (13) by means of articulation pins (14b, 14c).

8. A handling system (70) for handling a support (8) for at least one product to be sintered (P) by means of a sintering press, said handling system (70) comprising:
- a handling device (7) according to any one of the preceding claims;
- a support structure comprising device handling means (4, 5, 6) connected to the first support element (12).

9. Handling system (70) according to the preceding claim, wherein the device handling means (4, 5, 6) comprise at least one handling axis, said at least one handling axis being suitable for moving the handling device (7) along at least one predefined direction (X-X, Y-Y, Z-Z).

10. Handling system (70) according to the preceding claim, wherein the device handling means (4, 5, 6) comprise a first handling axis (4), a second handling axis (5) and a third handling axis (6) respectively suitable for moving the handling device (7) substantially along a first horizontal direction (X-X), a second horizontal direction (Y-Y) and a vertical direction (Z-Z).

11. A sintering press (100) for a sintering process of at least one product to be sintered (P) on a substrate, comprising:
- a handling system (70) according to any one of claims 8 to 10;
- a lower die (10a) on which a support (8) for at least one product to be sintered (P) is suitable for being positioned;
- an upper die (10b), at least one of the lower die (10a) and said upper die (10b) being movable with respect to the other between a retracted inactive position and an advanced pressing position;
- an actuator (18) suitable for moving at least one of the lower die (10a) and the upper die (10b) between the retracted inactive position and the advanced pressing position.

12. Sintering press (100) according to the preceding claim, further comprising:
- a preheating station (50) suitable for preheating the at least one product to be sintered (P);
- a cooling station (60) suitable for cooling the at least one product to be sintered (P) at the end of the sintering process;
wherein the support (8) is suitable for being positioned in the preheating station (50) and in the cooling station (60).

13. Sintering press (100) according to any one of claims 11 to 12, further comprising at least one conveyor belt (9) suitable for moving the support (8).

14. A method of sintering at least one product to be sintered (P) on at least one substrate (2), said method comprising the following operating steps:
a) providing a sintering press (100) according to any one of claims 11 to 13;
b) providing a support (8);
c) positioning the at least one substrate (2) on the support (8);
d) by means of the handling device (7), positioning the support (8) on the lower die (10a);
e) sintering the at least one product to be sintered (P).

15. Method of sintering according to the preceding claim, wherein step a) provides for providing a sintering press (100) according to any one of claims 12 to 13, and wherein after step c) and before step d), the following operating steps are provided:
c1) by means of the handling device (7), positioning the support (8) in the preheating station (50);
c2) preheating the at least one product to be sintered (P) ;
and wherein after step e), the following operating steps are provided:
e1) by means of the handling device (7), positioning the support (8) in the cooling station (60);
e2) cooling the at least one product to be sintered (P) at the end of the sintering process.
